(19) **Europäisches Patentamt**
**European Patent Office**
**Office européen des brevets**

(11) **EP 1 733 244 B1**

(12) **EUROPEAN PATENT SPECIFICATION**

(45) Date of publication and mention
of the grant of the patent:
**07.06.2017 Bulletin 2017/23**

(51) Int Cl.:
***G01R 31/36*** (2006.01)

(21) Application number: **05735309.6**

(86) International application number:
**PCT/US2005/011761**

(22) Date of filing: **06.04.2005**

(87) International publication number:
**WO 2005/101042 (27.10.2005 Gazette 2005/43)**

(54) **BATTERY STATE OF CHARGE ESTIMATOR**

SCHÄTZER FÜR DEN BATTERIELADUNGSZUSTAND

ETAT D'ACCUMULATEUR D'ESTIMATEUR DE CHARGE

(84) Designated Contracting States:
**DE FR GB IT**

(30) Priority: **06.04.2004 US 559921 P**
**16.03.2005 US 81978**
**16.03.2005 US 81979**
**16.03.2005 US 81980**

(43) Date of publication of application:
**20.12.2006 Bulletin 2006/51**

(60) Divisional application:
**06023772.4 / 1 754 977**
**06023773.2 / 1 752 780**

(73) Proprietor: **Cobasys, LLC**
**Orion MI 48359 (US)**

(72) Inventor: **MELICHAR, Robert**
**Troy, Michigan 48084 (US)**

(74) Representative: **Manitz Finsterwald Patentanwälte**
**PartmbB**
**Martin-Greif-Strasse 1**
**80336 München (DE)**

(56) References cited:
**EP-A- 0 560 468        EP-A- 1 085 592**
**EP-A- 1 220 413        US-A- 5 412 323**
**US-A- 6 160 380        US-A1- 2002 113 594**
**US-A1- 2003 112 011**

## Description

FIELD OF THE INVENTION

The present invention relates to battery systems, and more particularly to state of charge tracking systems for battery systems.

BACKGROUND OF THE INVENTION

Battery systems may be used to provide power in a wide variety applications. Exemplary transportation applications include hybrid electric vehicles (HEV), electric vehicles (EV), Heavy Duty Vehicles (HDV) and Vehicles with 42-volt electrical systems. Exemplary stationary applications include backup power for telecommunications systems, uninterruptible power supplies (UPS), and distributed power generation applications.

Examples of the types of batteries that are used include nickel metal hydride (NiMH) batteries, lead-acid batteries and other types of batteries. A battery system may include a plurality of battery subpacks that are connected in series and/or in parallel. The battery subpacks may include a plurality of batteries that are connected in parallel and/or in series.

The maximum and/or minimum power that can be delivered by batteries, battery subpacks and/or battery systems varies over time as a function of a temperature of the batteries, battery state of charge (SOC) and/or battery age. Therefore, accurate estimation of battery SOC is important to the determination of maximum and minimum power.

Document EP 0 560 468 A1 describes a battery monitoring device with the features of the preamble of claim 1. SOC is estimated under battery discharge, rest, and recharge conditions. An approximation of the operating parameters of the battery is provided under all conditions.

Document US 2002/0113594 A1 discloses a vehicle battery's open circuit voltage estimating system for relatively correctly estimating an open circuit voltage of a battery within a relatively short period after completion of the charge or the discharge.

The energy that can be provided by or sourced to a battery is a function of state of charge. When the battery state of charge is known and targeted during operation, an optimal ratio can maintained between the ability to accept amp-hours in charge and to provide amp-hours in discharge. As this optimal ratio can be maintained, there is a reduced need to oversize the battery system to assure adequate power assist and regeneration energy.

For example in transportation applications such as HEVs or EVs, it is important for the powertrain control system to know the maximum and/or minimum power limit of the battery system. The powertrain control system typically receives an input request for power from an accelerator pedal. The powertrain control system interprets the request for power relative to the maximum power limit of the battery system (when the battery system is powering the wheels). The minimum power limits may be relevant during recharging and/or regenerative braking. Exceeding the maximum and/or minimum power limits may damage the batteries and/or the battery system and/or reduce the operational life of the batteries and/or the battery system. Being able to estimate the battery SOC accurately has been somewhat problematic - particularly when the battery system includes NiMH batteries.

SUMMARY OF THE INVENTION

A battery control module for a battery system comprises a voltage measuring module that measures battery voltage and a current measuring module that measures battery current. A state of charge (SOC) module communicates with the current and voltage measuring modules and estimates SOC based on relaxation voltage.

The SOC module enables the SOC estimation when a qualified charge swing follows a discharge swing and relaxation. The SOC module enables the SOC estimation when a qualified discharge swing follows a charge swing and relaxation. The SOC module accumulates charge swing during charging and identifies the qualified charge swing when the accumulated charge swing is within a charge swing window. The SOC module accumulates discharge swing during discharging and identifies the qualified discharge swing when the accumulated discharge swing is within a discharge swing window.

In other features, the SOC module monitors rest periods during which the battery is neither charging nor discharging. The SOC module enables the SOC estimation when the rest period is greater than a threshold. The SOC module enables SOC estimation during charging when a first period between the qualified charge swing and the prior discharge swing and relaxation is less than a predetermined allowed time. The SOC module enables SOC estimation during charging when a second period between the qualified discharge swing and the prior charge swing and relaxation is less than a predetermined allowed time.

A battery control module for a battery system comprises a voltage measuring module that measures battery voltage and a current measuring module that measures battery current. A state of charge (SOC) module communicates with said current and voltage measuring modules and estimates SOC based on a power limit ratio.

In other features, the SOC module accumulates charge swing during charging, identifies maximum current during the charge swing and stores the maximum charge current, a charge swing and a charge power limit. The SOC module accumulates discharge swing during discharging, identifies maximum current during the discharge swing and stores the maximum discharge current, a discharge swing and a discharge power limit. The SOC module determines whether the charge swing is greater than a negative of a retained discharge swing.

In other features, the SOC module determines whether the maximum current is approximately equal to a negative of a retained discharge current. The SOC module includes a lookup table. The SOC module looks up the SOC as a function of the power limit ratio when the charge swing is greater than the retained discharge swing and the maximum current is approximately equal to the negative of the retained discharge current. The SOC module determines whether the discharge swing is greater than a negative of a retained charge swing.

In yet other features, the SOC module determines whether the maximum current is approximately equal to a negative of a retained charge current. The SOC module includes a lookup table. The SOC module looks up the SOC as a function of the power limit ratio when the discharge swing is greater than the retained charge swing and the maximum current is approximately equal to the negative of the retained charge current.

A battery control module for a battery system comprises a voltage measuring module that measures battery voltage and a current measuring module that measures battery current. A state of charge (SOC) module communicates with the current and voltage measuring modules and estimates SOC when an accumulated charge swing during charge is greater than or equal to an accumulated discharge swing during a prior discharge and a negative of a charge current is within a predetermined window of a negative of a retained discharge current during the prior discharge.

In other features, the SOC module estimates SOC when an accumulated discharge swing during discharge is greater than or equal to an accumulated charge swing during a prior charge and a negative of a discharge current is within a predetermined window of a negative of a retained charge current during the prior charge.

A battery control module for a battery system comprises a voltage measuring module that measures battery voltage and a current measuring module that measures battery current. A state of charge (SOC) module communicates with the current and voltage measuring modules and estimates SOC when an accumulated discharge swing during discharge is greater than or equal to an accumulated charge swing during a prior charge and a negative of a discharge current is within a predetermined window of a negative of a retained charge current during the prior charge.

Further areas of applicability of the present invention will become apparent from the detailed description provided hereinafter. It should be understood that the detailed description and specific examples, while indicating the preferred embodiment of the invention, are intended for purposes of illustration only and are not intended to limit the scope of the invention.

## BRIEF DESCRIPTION OF THE DRAWINGS

The present invention will become more fully understood from the detailed description and the accompanying drawings, wherein:

FIG. 1 is a functional block diagram of a battery system including battery subpacks, battery control modules and a master control module;
FIG. 2 is a more detailed functional block diagram of a battery control module;
FIG. 3 is an equivalent circuit of a battery;
FIG. 4 is a graph of battery current as a function of time;
FIGs. 5A and 5B are flowcharts illustrating steps of a relaxation voltage approach for estimating state of charge;
FIG. 6 is a graph of battery current as a function of time with charge and discharge swing and charge and discharge events shown; and
FIG. 7 is a flowchart illustrating a power ratio approach of estimating battery state of charge.

## DETAILED DESCRIPTION OF THE PREFERRED EMBODIMENTS

The following description of the preferred embodiment(s) is merely exemplary in nature and is in no way intended to limit the invention, its application, or uses. For purposes of clarity, the same reference numbers will be used in the drawings to identify the same elements. As used herein, the term module or device refers to an application specific integrated circuit (ASIC), an electronic circuit, a processor (shared, dedicated, or group) and memory that execute one or more software or firmware programs, a combinational logic circuit, and/or other suitable components that provide the described functionality. As used herein, the term current swing refers to current integrated over a duration during which the charge (polarity) is in one direction. Charge swing may be expressed in units of Amp-seconds or A-s.

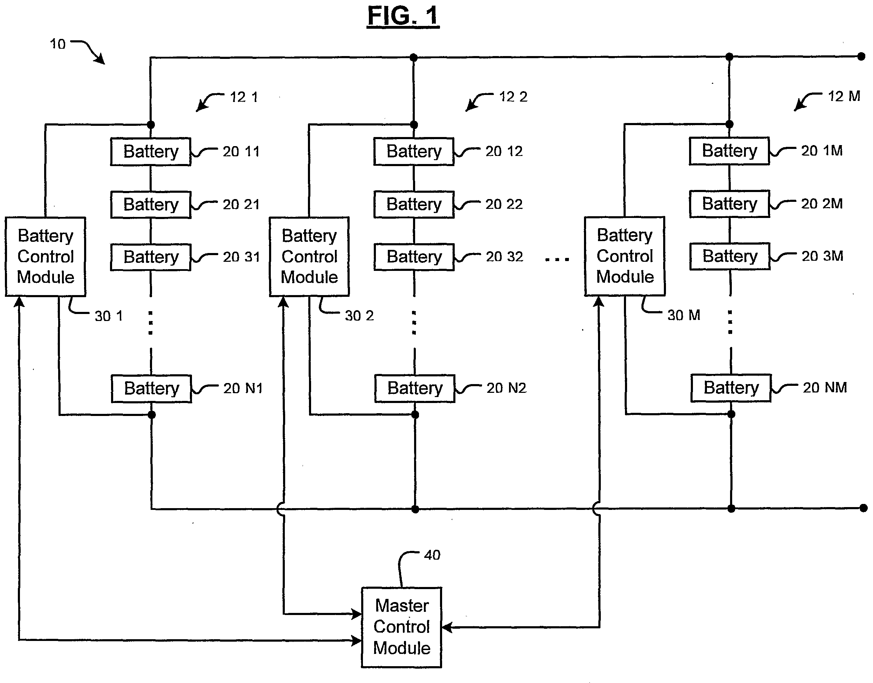

An exemplary system that can be used to calculate the SOC will be shown, although skilled artisans will appreciate that other systems may be used. Referring now to FIG. 1, an exemplary embodiment of a battery system 10 is shown to include M battery subpacks 12-1, 12-2, ..., and 12-M (collectively battery subpacks 12). The battery subpacks 12-1, 12-2, ..., and 12-M include N series connected batteries 20-11, 20-12, ..., and 20-NM (collectively batteries 20). Battery control modules 30-1, 30-2, ... and 30-M (collectively battery control modules 30) are associated with each of the battery subpacks 12-1, 12-2, ... and 12-M, respectively. In some embodiments, M is equal to 2 or 3, although additional or fewer subpacks may be used. In some embodiments, N is equal to 12-24, although additional and/or fewer batteries may be used.

The battery control modules 30 sense voltage across and current provided by the battery subpacks 12. Alternatively, the battery control modules 30 may monitor one or more individual batteries 20 in the battery subpacks 12 and appropriate scaling and/or adjustment is performed. The battery control modules 30 communicate with a master control module 40 using wireless and/or wired connections. The master control module 40 receives the power limits from the battery control modules 30 and generates a collective power limit. The SOC can be calculated for each module, in groups and/or collectively. The battery control module 30 may be integrated with the master control module 40 in some embodiments.

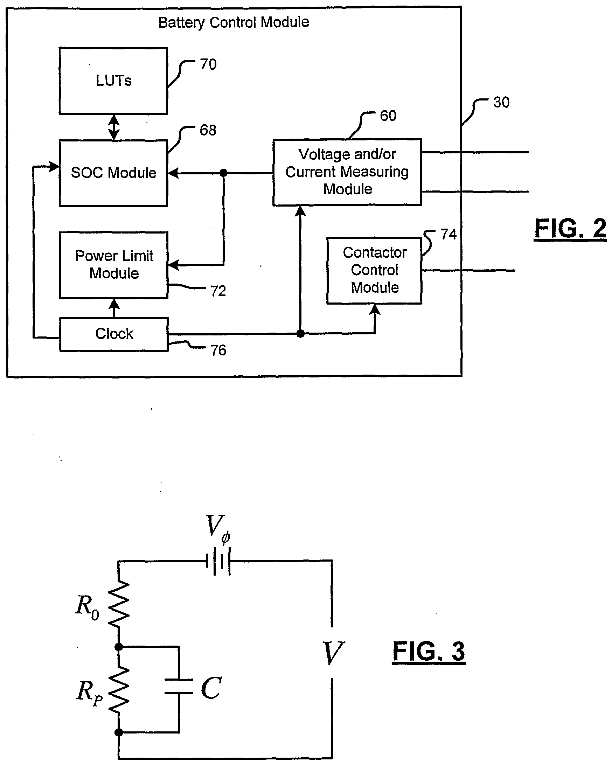

Referring now to FIG. 2, some of the elements of the battery control modules 30 are shown. The battery control modules 30 include a voltage and/or current measuring module 60 that measures voltage across the battery subpack 12 and/or across one or more individual batteries 20 in the battery subpack 12. The battery control modules 30 further include a battery state of charge (SOC) module 68 that periodically calculates the SOC of the batteries 20 in the battery subpacks 12. In one implementation, the SOC module 68 uses a power ratio estimation and/or $V_0$ approach, as will be described below. In another implementation, the SOC module 68 uses a relaxation voltage SOC estimation approach, as will be described below. The SOC module 68 may employ a lookup table 70, formulas and/or other methods.

A power limit module 72 calculates a maximum current limit $I_{lim}$, voltage limit $V_{lim}$, and/or power limit $P_{lim}$ for the battery subpack 12 and/or one or more batteries 20 in the battery subpack 12, as will be described further below. The limits may be maximum and/or minimum limits. A contactor control module 74 controls one or more contactors (not shown) that are associated with the control and/or connection of the batteries 20 in the battery subpacks 12. A clock circuit 76 generates one or more clock signals for one or more modules within the battery control module 30.

Referring now to FIG. 3, an equivalent circuit for the battery 20 is shown where $R_0$ represents ohmic resistance of the battery, $V_P$ represents the polarization voltage, $V_0$ represents the open circuit or relaxation voltage, $I$ represents battery current and $V$ represents battery voltage. $V$ and $I$ are measured values. $R_p$ varies with temperature, duration of applied current and SOC. $V_0$ and $R_0$ vary primarily with SOC. $V_P$ is equal to measured current $I$ times Rp. Using the equivalent circuit and Kirchoff's voltage rules for the battery 20, $V = V_0 + V_P + IR_0$.

Relaxation voltage is relatively insensitive to temperature and current demand and is a good indicator of SOC. A set of specialized current pulses can be used to condition the battery to yield SOC dependent relaxation voltages. This approach is referred to herein as relaxation voltage SOC estimation.

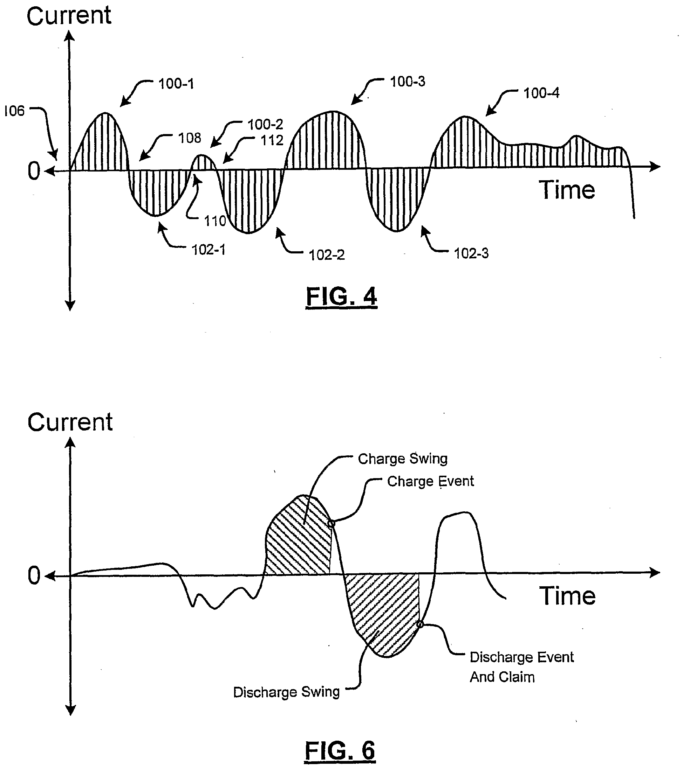

Referring now to FIG. 4, battery current is shown as a function of time. Current that is greater than zero, for example at 100-1, 100-2, 100-3, and 100-4, is charging current. Current that is less than zero, for example at 102-1, 102-2, and 102-3, is discharging current. The areas under the curve between points 106 and 108 and points 110 and 112 are defined as a charge swing in A-s. The area under the current curve between points 108 and 110 is defined as a discharge swing in A-s.

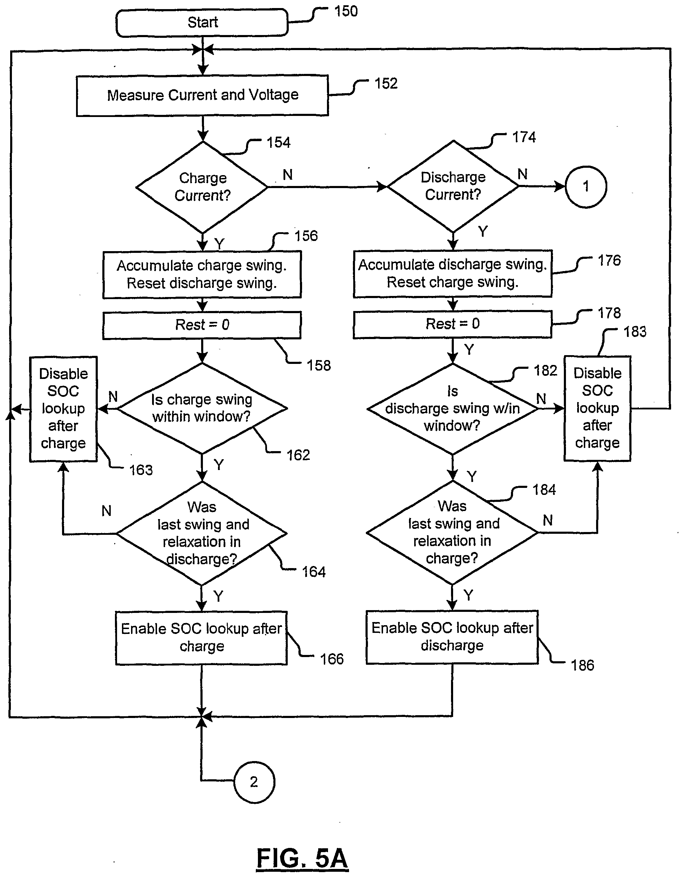

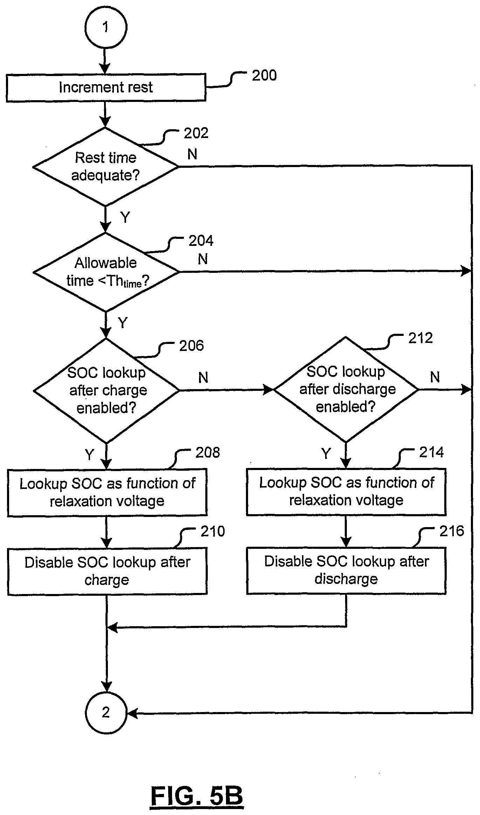

Referring now to FIGs. 5A and 5B, steps of a method for implementing a relaxation voltage SOC estimation approach are shown. The relaxation voltage estimation approach monitors battery current for a pair of power pulses, checks relaxation voltage after each and determines SOC using the lookup table 70. The relaxation voltage approach was derived based on the observation of voltage responses to pulses throughout a range operating of temperatures, such as -15°C to 45°C. The relaxation voltages were affected by swing amplitudes, pulse amplitudes and whether the battery was brought from top of charge or bottom of charge.

In FIGs. 5A and 5B, control begins with step 150. In step 152, the current and voltage are measured. In step 154, control determines whether the measured current is charge current (current > zero or a predetermined threshold). If step 154 is true, control accumulates charge swing and resets discharge swing in step 156. In step 158, control sets a rest variable equal to zero. In step 162, control determines whether the accumulated charge swing is within a predetermined window. The window may include upper and lower thresholds. In some implementations, the upper and lower thresholds are between 10% and 100% of battery capacity, although other values may be used. If not, control disables SOC lookup after charge in step 163 and returns to step 152.

If step 162 is true, control continues with step 164 and determines whether last swing and relaxation occurred in discharge. As used herein, relaxation refers to battery voltage asymptotically approaching the relaxation voltage. If not, control continues with step 163. If step 164 is true, control enables SOC lookup after charge in step 166.

If step 154 is false, control continues with step 174. In step 174, control determines whether the measured current is discharge current (current < zero or a predetermined threshold). If step 174 is true, control accumulates discharge swing and resets charge swing in step 176. In step 178, control sets the rest variable equal to zero. In step 182, control determines whether the accumulated discharge swing is within a predetermined window. The window may include upper and lower thresholds that may be similar to the accumulated charge swing thresholds or different therefrom. If not, control disables SOC lookup after discharge in step 183 and returns to step 152.

If step 182 is true, control continues with step 184 and determines whether last swing and relaxation occurred in charge. If not, control continues with step 183. If step 184 is true, control enables SOC lookup after discharge in step 186.

If step 174 is false, control continues in FIG. 5B with step 200 and increments the rest variable. In step 202, control determines whether rest time is adequate by comparing rest time to a threshold. In some implementations, approximately 120 seconds is used as a threshold, although other values may be used. If step 202 is true, control determines whether allowable time is less than a threshold time $Th_{time}$ in step 204. In some implementations, allowable time is equal to 240 seconds, although other values may be used. Exceeding this value tends to indicate that the pulses were not controlled enough for an SOC estimation.

If step 204 is true, control continues with step 206 and determines whether SOC lookup after charge is enabled. If step 206 is true, control looks up SOC as a function of relaxation voltage in step 208 and disables SOC lookup after charge in step 210 and control returns to step 152. If step 206 is false, control continues with step 212 and determines whether SOC lookup after discharge is enabled. If step 212 is true, control looks up SOC as a function of relaxation voltage in step 214 and disables SOC lookup after discharge in step 216 and control returns to step 152. If steps 202, 204 or 212 are false, control returns to step 152.

The power ratio SOC estimation approach monitors power pulse pairs. The method calculates the ratio of power capabilities in charge and discharge when the swings of the pulse pairs are approximately equal. The SOC is a function of the power ratio and is determined by a lookup table. The algorithm was derived while attempting to use inputs of current and voltage to solve for relaxation voltage $V_0$.

The voltage equation as the maximum or minimum power is held to a voltage limit is $V_{lim} = V_0 + V_P + I_{lim} R_0$. Substitution of the calculation for $V_0 + V_P$ from a prior sampling interval into the equation for $V_{lim}$ yields $V_{lim} = (V-IR_o)+I_{lim}R_o$. In this case, we are assuming that $V_0+V_P$ for the current sampling interval is approximately equal to $V_0 + V_P$ of the prior sampling interval (in other words, $V_0 + V_P \cong V_{t=i-1}-I_{t=i-1}R_0$). This approximation is valid if the sampling interval is sufficiently small since the battery and ambient conditions are very similar. For example in some implementations, a sampling interval $10ms<T<500ms$ may be used, although other sampling intervals may be used. In one embodiment, T=100ms. Sampling intervals of 1 second have been used successfully. If the sampling interval is determined to be excessive in duration then $R_o$ would be increased as a constant or as a temperature dependent variable.

Solving for $I_{lim}$ yields the following:

$$ I_{\text{lim}} = \frac{V_{\text{lim}} - V_{t=i-1} + I_{t=i-1} R_0}{R_0}. $$

Therefore, since $P_{lim} = V_{lim} I_{lim}$,

$$ P_{\text{lim}} = V_{\text{lim}} \left( \frac{V_{\text{lim}} - V_{t=i-1} + I_{t=i-1} R_0}{R_0} \right). $$

At the time that power limit is established for a charge or discharge swing and measured current, the measured current and voltage values are stored. When the current is reversed, the swing amplitude passes the negative of the retained swing, and the current is approximately equal to the magnitude of the retained current, a power limit calculation is performed.

The power ratio is calculated by taking $P_{lim}$ in charge divided by $-P_{lim}$ in discharge for adjacent cycles. Even though $V_0$ and $V_p$ are no longer in the equation, their contributions are reflected in current and voltage measurements, which are functions of both the polarization build up and $V_0$. The polarization voltage $V_p$ during a charge swing is approximately equal to the polarization voltage $V_p$ during a discharge swing of approximately equal magnitude. Using this approximation, the power ratio SOC estimation is used to remove $V_p$ from the calculation. The use of the power limit ratio has the effect of adding consideration of the low discharge power at low SOC and the low charge acceptance at high SOC to the stated charge determination.

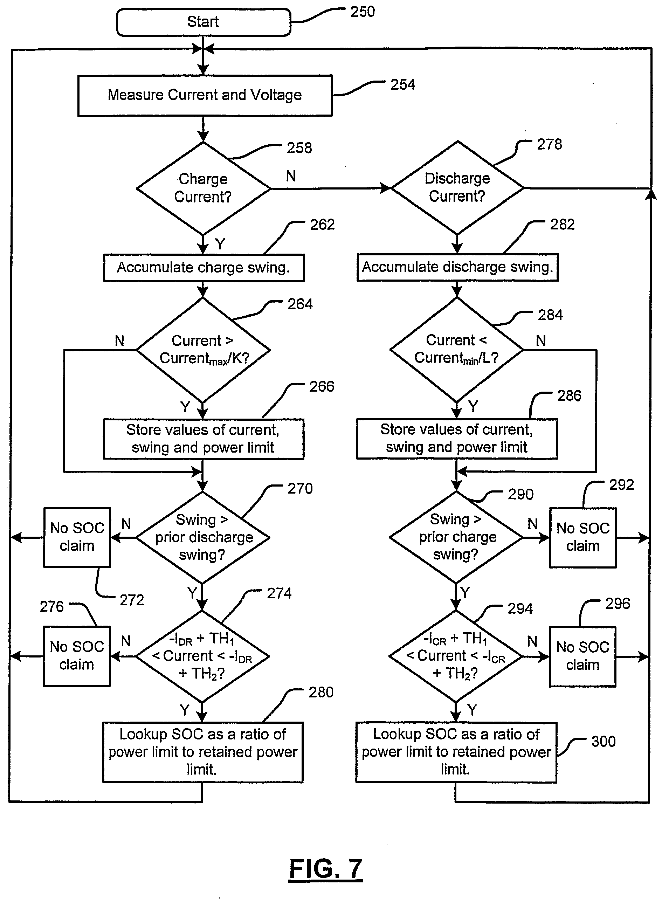

In FIG. 6, the battery current is shown. The present invention monitors charge and discharge swing and declares charge and discharge events under certain circumstances. A charge swing event occurs when the charge swing is greater than a charge swing threshold. A discharge event occurs when a discharge swing is greater than a discharge swing threshold. The thresholds may be related to or based on a prior charge or discharge event. For example, a charge swing threshold may be set equal to the absolute value of a prior discharge event. A discharge swing threshold may be set equal to the absolute value of a prior charge event. Still other approaches may be used to determine the charge and discharge thresholds. As used herein, the term claim refers to situations when a charge or discharge event is followed by a discharge or charge claim and when other conditions described below are met. The occurrence of discharge event is determined independently from the occurrence of the discharge claim, to different criteria. The algorithm looks for both simultaneously. For example, the claim point occurs at the time that the area discharge swing is equal to the previous charge swing. The event point occurs when the ratio current vs. discharge current MIN is roughly equal to the ratio current at charge event vs. charge current MAX. This would be the case if L = K in FIG. 7. In some implementations, L and K are between 1 and 2, although other values may be used.

Referring now to FIG. 7, the power ratio SOC estimation method according to the present invention is shown in further detail. Control begins with step 250. In step 254, control measures current and voltage. In step 258, control determines whether there is a charge current. Charge current is defined by positive current above zero or a predetermined positive threshold. If step 258 is true, control continues with step 262 and accumulates charge swing. In step 264, control determines whether the current during the charge swing passes a maximum value and is greater than $Current_{max}/K$. When step 264 is true, control stores values of current, charge swing and power limit in step 266. If not, control continues past step 266 to step 270. In step 270, control determines whether the swing is greater than the prior discharge swing. If not, control does not make an SOC claim in step 272 and control continues with step 254.

If step 270 is true, control determines whether the current is approximately equal to a retained discharge current $-I_{DR}$ (in other words within upper and lower thresholds thereof) in step 274. If step 274 is false, control does not make an SOC claim in step 276 and control continues with step 254. If step 274 is true, control looks up SOC as a ratio of power limit to retained power limit in step 280.

If step 258 is false, control continues with step 278 and determines whether discharge current is present. Discharge current is present when discharge current is less than zero or a predetermined negative threshold. If step 278 is false, control returns to step 254. If step 278 is true, control continues with step 282 and accumulates discharge swing. In step 284, control determines whether the current during the discharge swing passes a minimum value and is less than $Current_{min}/L$. When step 284 is true, control stores values of current, the discharge swing and power limit in step 286. If not, control continues past step 286 to step 290. In step 290, control determines whether the discharge swing is greater than the prior charge swing. If not, control does not make an SOC claim in step 292 and control continues with step 254.

If step 290 is true, control determines whether the current is approximately equal to a retained charge current $-I_{CR}$ (in other words within upper and lower thresholds thereof) in step 294. If step 294 is false, control does not make an SOC claim in step 296 and control continues with step 294. If step 294 is true, control looks up SOC as a ratio of power limit to retained power limit in step 300.

**Claims**

1. A battery control module for a battery system, comprising:

   a voltage measuring module that measures battery voltage;
   a current measuring module that measures battery current; and
   a state of charge (SOC) module that is adapted to communicate with said current and voltage measuring modules and estimate SOC based on relaxation voltage, battery voltage and battery current, **characterized in that** said SOC module is adapted to determine at least one of i) whether a charge swing is within a first predetermined window of battery capacity, and ii) whether a discharge swing is within a second predetermined window of the battery capacity, wherein said SOC module is adapted to enable said estimation of said SOC if at least one of i) the charge swing follows a discharge swing within the first predetermined window and ii) the discharge swing follows a charge swing within the second predetermined window, and wherein said SOC module is adapted to disable said estimation of said SOC if at least one of i) the charge swing does not follow a discharge swing within the first predetermined window and ii) the discharge swing does not follow a charge swing within the second predetermined window.

2. The battery control module of Claim 1 wherein said SOC module is adapted to monitor rest periods during which said battery is neither charging nor discharging.

3. The battery control module of Claim 2 wherein said SOC module is adapted to enable said SOC estimation when said rest period is greater than a threshold.

4. The battery control module of Claim 1 wherein said SOC module is adapted to enable SOC estimation during charging when a first period between said a charge swing and a prior discharge swing and relaxation is less than a predetermined allowed time.

5. The battery control module of Claim 1 wherein said SOC module is adapted to SOC estimation during charging when a second period between said discharge swing and a prior charge swing and relaxation is less than a predetermined allowed time.

6. A method for operating a battery control module for a battery system, comprising:

   measuring battery voltage;
   measuring battery current;
   estimating state of charge (SOC) based on relaxation voltage, said battery voltage and said battery current;
   **characterised by** determining at i) whether a charge swing is within a first predetermined window of battery capacity, and ii) whether a discharge swing is within a second predetermined window of the battery capacity;
   enabling said estimation of said SOC if at least one of i) the charge swing follows a discharge swing within the first predetermined window and ii) the discharge swing follows a charge swing within the second predetermined window; and
   disabling said estimation of said SOC if at least one of i) the charge swing does not follow a discharge swing within the first predetermined window and ii) the discharge swing does not follow a charge swing within the second predetermined window.

7. The method of Claim 6 further comprising monitoring rest periods during which said battery is neither charging nor discharging.

8. The method of Claim 7 further comprising enabling said SOC estimation when said rest period is greater than a threshold.

9. The method of Claim 6 further comprising enabling SOC estimation during charging when a first period between said charge swing and a prior discharge swing and relaxation is less than a predetermined allowed time.

10. The method of Claim 6 further comprising enabling SOC estimation during charging when a second period between said discharge swing and a prior charge swing and relaxation is less than a predetermined allowed time.

**Patentansprüche**

1. Batteriesteuerungsmodul für ein Batteriesystem, umfassend:

ein Spannungsmessmodul, das eine Batteriespannung misst;
ein Strommessmodul, das einen Batteriestrom misst; und
ein Ladezustandsmodul (SOC-Modul), das geeignet ist, um mit dem Strommessmodul und dem Spannungsmessmodul zu kommunizieren und um einen SOC auf der Grundlage einer Relaxations-Spannung, der Batteriespannung und des Batteriestroms zu schätzen,

**dadurch gekennzeichnet, dass**
das SOC-Modul geeignet ist, um zu ermitteln,

i) ob ein Ladehub in einem ersten vorbestimmten Fenster einer Batteriekapazität liegt, und/oder ii) ob ein Entladehub in einem zweiten vorbestimmten Fenster der Batteriekapazität liegt,

wobei das SOC-Modul geeignet ist, um die Schätzung des SOC zu ermöglichen, wenn

i) der Ladehub einem Entladehub innerhalb des ersten vorbestimmten Fensters folgt und/oder ii) der Entladehub einem Ladehub innerhalb des zweiten vorbestimmten Fensters folgt, und

wobei das SOC-Modul geeignet ist, um die Schätzung des SOC zu deaktivieren, wenn

i) der Ladehub einem Entladehub nicht innerhalb des ersten vorbestimmten Fensters folgt und/oder ii) der Entladehub einem Ladehub nicht innerhalb des zweiten vorbestimmten Fensters folgt.

2. Batteriesteuerungsmodul nach Anspruch 1, wobei das SOC-Modul geeignet ist, um Ruheperioden zu überwachen, während denen die Batterie weder geladen noch entladen wird.

3. Batteriesteuerungsmodul nach Anspruch 2, wobei das SOC-Modul geeignet ist, um die SOC-Schätzung zu ermöglichen, wenn die Ruheperiode größer als ein Schwellenwert ist.

4. Batteriesteuerungsmodul nach Anspruch 1, wobei das SOC-Modul geeignet ist, um die SOC-Schätzung beim Laden zu ermöglichen, wenn eine erste Periode zwischen dem Ladehub und einem vorherigen Entladehub und einer Relaxation kleiner als eine vorbestimmte zulässige Zeit ist.

5. Batteriesteuerungsmodul nach Anspruch 1, wobei das SOC-Modul geeignet ist, um die SOC-Schätzung beim Laden [zu ermöglichen], wenn eine zweite Periode zwischen dem Entladehub und einem vorherigen Ladehub und einer Relaxation kleiner als eine vorbestimmte zulässige Zeit ist.

6. Verfahren zum Betreiben eines Batteriesteuerungsmoduls für ein Batteriesystem, wobei das Verfahren umfasst, dass:

eine Batteriespannung gemessen wird;
ein Batteriestrom gemessen wird;
ein Ladezustand (SOC) auf der Grundlage einer Relaxationsspannung, der Batteriespannung und des Batteriestroms geschätzt wird, **dadurch gekennzeichnet, dass**
ermittelt wird, i) ob ein Ladehub innerhalb eines ersten vorbestimmten Fensters einer Batteriekapazität liegt, und[/oder] ii) ob ein Entladehub innerhalb eines zweiten vorbestimmten Fensters der Batteriekapazität liegt;
die Schätzung des SOC ermöglicht wird, wenn i) der Ladehub einem Entladehub innerhalb des ersten vorbestimmten Fensters folgt und/oder ii) der Entladehub einem Ladehub innerhalb des zweiten vorbestimmten Fensters folgt; und
die Schätzung des SOC deaktiviert wird, wenn i) der Ladehub einem Entladehub nicht innerhalb des ersten vorbestimmten Fensters folgt und/oder ii) der Entladehub einem Ladehub nicht innerhalb des zweiten vorbestimmten Fensters folgt.

7. Verfahren nach Anspruch 6,
das ferner umfasst, dass Ruheperioden überwacht werden, während denen die Batterie weder geladen noch entladen wird.

8. Verfahren nach Anspruch 7,
das ferner umfasst, dass die SOC-Schätzung ermöglicht wird, wenn die Ruheperiode größer als ein Schwellenwert ist.

9. Verfahren nach Anspruch 6,
das ferner umfasst, dass die SOC-Schätzung beim Laden ermöglicht wird, wenn eine erste Periode zwischen dem Ladehub und einem vorherigen Entladehub und einer Relaxation kleiner als eine vorbestimmte zulässige Zeit ist.

10. Verfahren nach Anspruch 6,
das ferner umfasst, dass die SOC-Schätzung beim Laden ermöglicht wird, wenn eine zweite Periode zwischen dem Entladehub und einem vorherigen Ladehub und einer Relaxation kleiner als eine vorbestimmte zulässige Zeit ist..

**Revendications**

1. Module de commande de batterie pour un système de batterie, comprenant :

   un module de mesure de voltage qui mesure un voltage de batterie ;
   un module de mesure de courant qui mesure un courant de batterie ; et
   un module d'état de charge (SOC) qui est adapté à communiquer avec lesdits modules de mesure de courant et de voltage et à estimer un SOC sur la base d'un voltage de relaxation, d'un voltage de batterie et d'un courant de batterie, **caractérisé en ce que**
   ledit module SOC est adapté à déterminer au moins une situation i) quant à savoir si une variation de charge tombe à l'intérieur d'une première fenêtre prédéterminée de capacité de batterie, et ii) quant à savoir si une variation de décharge tombe à l'intérieur d'une seconde fenêtre prédéterminée de la capacité de batterie,
   dans lequel ledit module SOC est adapté à permettre ladite estimation dudit SOC dans l'un au moins des cas suivants i) la variation de charge suit une variation de décharge qui tombe à l'intérieur de la première fenêtre prédéterminée et ii) la variation de décharge suit une variation de charge qui tombe à l'intérieur de la seconde fenêtre prédéterminée, et
dans lequel ledit module SOC est adapté à désactiver ladite estimation dudit SOC dans l'un au moins des cas suivants i) la variation de charge ne suit pas une variation de décharge qui tombe à l'intérieur de la première fenêtre prédéterminée, et ii) la variation de décharge ne suit pas une variation de charge qui tombe à l'intérieur de la seconde fenêtre prédéterminée.

2. Module de commande de batterie selon la revendication 1, dans lequel ledit module SOC est adapté à surveiller des périodes de repos pendant lesquelles ladite batterie n'est ni en cours de charge ni en cours de décharge.

3. Module de commande de batterie selon la revendication 2, dans lequel ledit module SOC est adapté à permettre ladite estimation du SOC quand ladite période de repos est plus grande qu'un seuil.

4. Module de commande de batterie selon la revendication 1, dans lequel ledit module SOC est adapté à permettre l'estimation du SOC pendant le processus de charge quand une première période entre ladite variation de charge et une variation de décharge antérieure et relaxation est inférieure à un temps autorisé prédéterminé.

5. Module de commande de batterie selon la revendication 1, dans lequel ledit module SOC est adapté à estimer le SOC pendant le processus de charge quand une seconde période entre ladite variation de décharge et une variation de décharge antérieure et relaxation est inférieure à un temps autorisé prédéterminé.

6. Procédé pour faire fonctionner un module de commande de batterie pour un système de batterie, comprenant les étapes consistant à :

   mesurer un voltage de batterie ;
   mesurer un courant de batterie ;
   estimer l'état de charge (SOC) sur la base du voltage de relaxation, dudit voltage de batterie et dudit courant de batterie ;
   **caractérisé par** les étapes consistant à
   déterminer i) quant à savoir si une variation de charge tombe à l'intérieur d'une première fenêtre prédéterminée d'une capacité de batterie, et ii) quant à savoir si une variation de décharge tombe à l'intérieur d'une seconde fenêtre prédéterminée de la capacité de batterie ;
   permettre ladite estimation dudit SOC dans l'un au moins des cas suivants i) la variation de charge suit une variation de décharge qui tombe à l'intérieur de la première fenêtre prédéterminée et ii) la variation de décharge suit une variation de charge qui tombe à l'intérieur de la seconde fenêtre prédéterminée ; et

désactiver ladite estimation dudit SOC dans l'un au moins des cas suivants i) la variation de charge ne suit pas une variation de charge qui tombe à l'intérieur de la première fenêtre prédéterminée et ii) la variation de décharge ne suit pas une variation de charge qui tombe à l'intérieur de la seconde fenêtre prédéterminée.

7.   Procédé selon la revendication 6, comprenant en outre l'étape consistant à surveiller des périodes de repos pendant lesquelles ladite batterie n'est ni en cours de charge ni en cours de décharge.

8.   Procédé selon la revendication 7, comprenant en outre l'étape consistant à permettre ladite estimation du SOC quand ladite période de repos est plus grande qu'un seuil.

9.   Procédé selon la revendication 6, comprenant en outre l'étape consistant à permettre ladite estimation du SOC pendant un processus de charge quand une première période entre ladite variation de charge et une variation de décharge antérieure et relaxation est inférieure à un temps autorisé prédéterminé.

10.  Procédé selon la revendication 6, comprenant en outre l'étape consistant à permettre ladite estimation du SOC pendant un processus de charge quand une seconde période entre ladite variation de décharge et une variation de charge antérieure et relaxation est inférieure à un temps autorisé prédéterminé.

FIG. 1

Battery Control Module

LUTs — 70

SOC Module — 68

Voltage and/or Current Measuring Module — 60

— 30

Power Limit Module — 72

Contactor Control Module — 74

Clock — 76

**FIG. 2**

$V_\phi$

$R_0$

$R_P$

$C$

$V$

**FIG. 3**

Current

**FIG. 4**

Current

**FIG. 6**

**FIG. 5A**

① 

Increment rest — 200

Rest time
adequate? — 202 — N

Y

Allowable
time <Th$_{time}$? — 204 — N

Y

SOC lookup
after charge
enabled? — 206 — N

SOC lookup
after discharge
enabled? — 212 — N

Y — 208

Lookup SOC as function of
relaxation voltage

Y — 214

Lookup SOC as function of
relaxation voltage

— 210

Disable SOC lookup after
charge

— 216

Disable SOC lookup after
discharge

②

**FIG. 5B**

Start — 250

Measure Current and Voltage — 254

258 — Charge Current? — N → Discharge Current? — 278

Y

262 — Accumulate charge swing.

282 — Accumulate discharge swing.

264 — N — Current > Current$_{max}$/K?

284 — Current < Current$_{min}$/L? — N

Y

266 — Store values of current, swing and power limit

286 — Store values of current, swing and power limit

270 — Swing > prior discharge swing? — N → No SOC claim — 272

290 — Swing > prior charge swing? — N → No SOC claim — 292

Y

274 — -I$_{DR}$ + TH$_1$ < Current < -I$_{DR}$ + TH$_2$? — N → No SOC claim — 276

294 — -I$_{CR}$ + TH$_1$ < Current < -I$_{CR}$ + TH$_2$? — N → No SOC claim — 296

Y

280 — Lookup SOC as a ratio of power limit to retained power limit.

300 — Lookup SOC as a ratio of power limit to retained power limit.

## FIG. 7

15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0560468 A1
- US 20020113594 A1